# FASCICULE DE BREVET EUROPEEN

(11) **EP 3 916 763 B1**
(45) Date de publication et mention de la délivrance du brevet: **03.01.2024**
(21) Numéro de dépôt: 21176158.0
(22) Date de dépôt: 27.05.2021
(51) Int. Cl.: H01L 21/67, H01L 21/683, H01L 21/687

(54) **SYSTÈME DE POSITIONNEMENT D'UNE PLAQUE**
SYSTEM ZUR POSITIONIERUNG EINER PLATTE
SYSTEM FOR POSITIONING A PLATE

(30) Priorité: 29.05.2020 FR 2005725
(43) Date de publication de la demande: 01.12.2021
(73) Titulaire: Commissariat à l'énergie atomique et aux énergies alternatives, 75015 Paris (FR)
(72) Inventeur: BOUTRY, Delphine, 38054 GRENOBLE CEDEX 09 (FR); AUTILLO, Delphine, 38054 GRENOBLE CEDEX 09 (FR); ENYEDI, Virginie, 38054 GRENOBLE CEDEX 09 (FR); ENYEDI, Grégory, 38054 GRENOBLE CEDEX 09 (FR)
(74) Mandataire: Brevalex

(56) Documents cités:
- WO-A1-2008/018731
- US-A- 5 692 873
- US-A1- 2020 043 756
- US-B1- 6 293 749

## Description

### DOMAIN TECHNIQUE ET ÉTAT DE LA TECHNIQUE ANTÉRIEURE

La présente invention se rapporte à un système de positionnement d'une plaque et de positionnement d'un dispositif de manipulation de cette plaque.

Dans le domaine de la microélectronique, on utilise des substrats ou wafers sur lesquels on réalise des circuits électroniques. Or les contaminants, par exemple des éléments métalliques même sous forme de trace, peuvent entraîner des baisses des performances électriques. Cette contamination peut survenir à chaque étape de fabrication de circuits électroniques sur un substrat, par exemple en silicium. La contamination, notamment en face arrière ou sur la tranche ou bevel, peut être due aux dispositifs servant à la manipulation des substrats, par exemple les pinces ou les équipements servant à transférer les substrats d'une boîte à l'autre, désignés « sorter », ou encore les boîtes de rangement des substrats.

Afin de limiter les risques de contamination des bords de plaque, on utilise un dispositif de manipulation sous vide désigné vacuum chuck en terminologie anglo-saxonne. Le dispositif de manipulation sous vide comporte une cavité qui peut être reliée à une source de vide, celle-ci est mise en contact avec une face de la plaque, le vide est généré dans la cavité, la plaque est alors solidarisée au dispositif de manipulation et peut être déplacée sans entrer en contact avec le bord de la plaque.

Le document FR1873425 déposé le 19 décembre 2018 décrit un dispositif de collecte de contaminants de bord de plaque comprenant un support sur lequel est monté le substrat capable de tourner autour d'un axe horizontal et une gouttière contenant un liquide de collecte et recevant une partie du bord de la plaque. Le substrat est supporté verticalement par un dispositif de manipulation sous vide. En faisant tourner le substrat sur lui-même, tout le bord du substrat est balayé par le liquide dans la gouttière. Cette technique requiert un très bon centrage du dispositif de manipulation par rapport au substrat afin d'assurer une hauteur de collecte sur le bord du substrat sensiblement constante sur toute la périphérie de la plaque.

Par ailleurs, dans un procédé de collage de deux plaques, un alignement des deux plaques est requis. Or cet alignement peut être complexe à obtenir, notamment du fait des contraintes lors de la manipulation des plaques.

Il est aussi fait référence aux documents de l'état de l'art suivant: If

US 5692873 A décrit un dispositif de support de galette à semi-conducteur utilisé dans un système de manufacture. If

US 6293749 B1 décrit un dispositif de support de galette à semi-conducteur compris dans un système de transfert. If

US 2020/043756 A1 décrit un dispositif de support de galette à semi-conducteur compris dans un système de nettoyage sans contact. If

### EXPOSÉ DE L'INVENTION

C'est par conséquent un but de la présente invention de résoudre les inconvénients mentionnés ci-dessus.

Le but énoncé ci-dessus est atteint par un système de positionnement d'un dispositif de manipulation de plaques par rapport à une face d'une plaque, comportant un plateau, des éléments de positionnement de la plaque par rapport au plateau, un logement de montage du dispositif de manipulation, ledit logement étant situé par rapport aux éléments de positionnement de sorte que, lorsque le dispositif de manipulation est positionné dans le logement de montage et le bord de plaque est en contact avec les éléments de positionnement, le dispositif de manipulation est correctement positionné par rapport à une face de la plaque.

Le dispositif de manipulation comporte une face apte à venir en contact avec une face de la plaque pour se solidariser à celle-ci, et qui est configuré pour coopérer avec le logement du système de positionnement de sorte que la face du dispositif de manipulation soit immobilisée par rapport au plateau et soit du côté de la face du plateau recevant la plaque.

Le système de positionnement met en oeuvre un système intermédiaire dans lequel la plaque est dans une position donnée et le dispositif de manipulation a une position donnée. Il en résulte que le dispositif de manipulation a une position donnée par rapport à la plaque.

Grâce à l'invention, le positionnement du dispositif de manipulation par rapport à la plaque est toujours correct.

Dans un exemple très avantageux, le système de positionnement est conçu pour limiter les étapes de manipulation de la plaque.

De manière préférée, les éléments de positionnement comportent au moins trois pions avec lesquels le contour de plaque est destiné à être en contact. Le contact entre la plaque et le système de positionnement est alors réduit.

De manière très avantageuse, les pions sont amovibles et peuvent être facilement nettoyés pour limiter encore davantage la contamination du bord de plaque.

Le système de positionnement peut être très avantageusement mis en oeuvre dans un dispositif de collages de substrats.

L'un des objets de la présente demande est alors un système de positionnement pour positionner un dispositif de manipulation de plaque par rapport à une plaque de forme donnée, ledit dispositif de manipulation comportant une face de solidarisation destinée à être solidarisée à une face de la plaque, ledit système comprenant :
- un plateau comportant une première face et une deuxième face, la deuxième face étant destinée à être au moins en partie en regard d'une face de la plaque,
- un support supportant le plateau,
- des éléments de positionnement pour positionner la plaque par rapport au plateau, lesdits éléments de positionnement étant portés par la deuxième face du plateau,
- un logement pour monter le dispositif de manipulation dans le plateau, de sorte que ladite face de solidarisation du dispositif de manipulation soit orientée du côté de la deuxième face du plateau, la position du logement par rapport aux éléments de positionnement assurant le positionnement du dispositif de manipulation par rapport à la plaque.

Le logement débouche de préférence dans le contour du plateau pour permettre la mise en place et le retrait du dispositif de manipulation.

De préférence, les éléments de positionnement sont configurés pour venir en contact avec un contour extérieur de la plaque de sorte à former une butée en translation pour la plaque dans un plan parallèle à celui de la deuxième face du plateau ou dans un plan confondu avec celui de la deuxième face du plateau. Par exemple, les éléments de positionnement comportent au moins trois pions en saillie de la deuxième face du plateau et disposés les uns par rapport aux autres de sorte à délimiter entre eux le contour extérieur de la plaque.

Le plateau peut comporter une ouverture définissant le logement pour le dispositif de manipulation, l'ouverture présentant des bords configurés pour venir en butée contre le dispositif de manipulation.

Très avantageusement, le système de positionnement comporte des moyens de surélévation de la plaque portée par le dispositif de manipulation par rapport au plateau. Le plateau comporte avantageusement des moyens d'immobilisation pour immobiliser le dispositif de manipulation dans le plan du plateau. Par exemple, les moyens d'immobilisation comportent une rainure dans les bords de l'ouverture.

Par exemple, les éléments de positionnement délimitent une zone circulaire configurée pour positionner une plaque en forme de disque, les pions étant avantageusement amovibles pour autoriser leur nettoyage.

Avantageusement, au moins les éléments de positionnement sont en polytétrafluoroéthylène. De préférence à la fois le système de positionnement et le dispositif de manipulation sont en polytétrafluoroéthylène.

Un autre objet de la présente demande est un ensemble de manipulation comportant un système de positionnement selon la présente demande et un dispositif de manipulation comportant un corps, une tête munie d'une face de solidarisation, la tête étant configurée pour que la face de solidarisation soit orientée du côté de la deuxième face du plateau et le corps soit de l'autre côté du plateau par rapport à la face de solidarisation. Selon une caractéristique additionnelle, la tête du dispositif de manipulation comporte des dimensions supérieures à la dimension transversale du logement, et la tête est reliée au corps par une partie de jonction de dimensions transversales inférieures à la dimension transversale du logement, de sorte que la tête puisse reposer sur la deuxième face du plateau et que la partie de jonction puisse coulisser dans le logement.

Selon une caractéristique additionnelle, le dispositif de manipulation comporte au moins un canal débouchant dans la face de solidarisation et relié à une source de dépression. De préférence, la face de solidarisation comporte des rainures reliées au canal.

Par exemple, la face de solidarisation comporte des premières rainures en cercles concentriques de différents diamètres et au moins une deuxième rainure rectiligne disposée radialement et croisant les première rainures, lesdites première rainure et ladite au moins deuxième rainure étant reliées au canal.

Un autre objet de la présente demande est un ensemble d'assemblage pour l'assemblage de deux plaques comportant deux ensembles de manipulation selon la présente demande, ledit ensemble étant avantageusement configuré pour assembler deux plaques en forme de disque comportant chacune un méplat ou une encoche sur son contour, les éléments de positionnement d'au moins un système de positionnement étant tels qu'ils imposent une localisation du méplat ou de l'encoche sur le plateau.

Un autre objet de la présente demande est un procédé d'assemblage d'une première et d'une deuxième plaque mettant en oeuvre l'ensemble d'assemblage selon la présente demande, comportant :
- Mise en place dans le premier et le deuxième système de positionnement du premier et deuxième dispositif de manipulation respectivement.
- Mise en place des première et deuxième plaques sur les premier et deuxième dispositifs de positionnement respectivement.
- Solidarisation des première et deuxième plaques au premier et deuxième dispositif de manipulation respectivement.
- Retrait du deuxième dispositif de manipulation et de la deuxième plaque du deuxième dispositif de positionnement.
- Rapprochement de la deuxième plaque de la première plaque.
- Mise en contact des première et deuxième plaques par leur face opposée à celle en contact avec les premier et deuxième dispositifs de manipulation.

### BRÈVE DESCRIPTION DES DESSINS

La présente invention sera mieux comprise sur la base de la description qui va suivre et des dessins en annexe sur lesquels:
La figure 1 est une vue en perspective d'un exemple d'un système de positionnement d'un dispositif de manipulation de plaque,
La figure 2A est une vue en perspective d'un exemple de dispositif de manipulation destiné à coopérer avec le système de positionnement, une plaque étant solidarisée au dispositif de manipulation,
La figure 2B est une vue de la face de solidarisation du dispositif de manipulation de la figure 2A selon un exemple de réalisation,

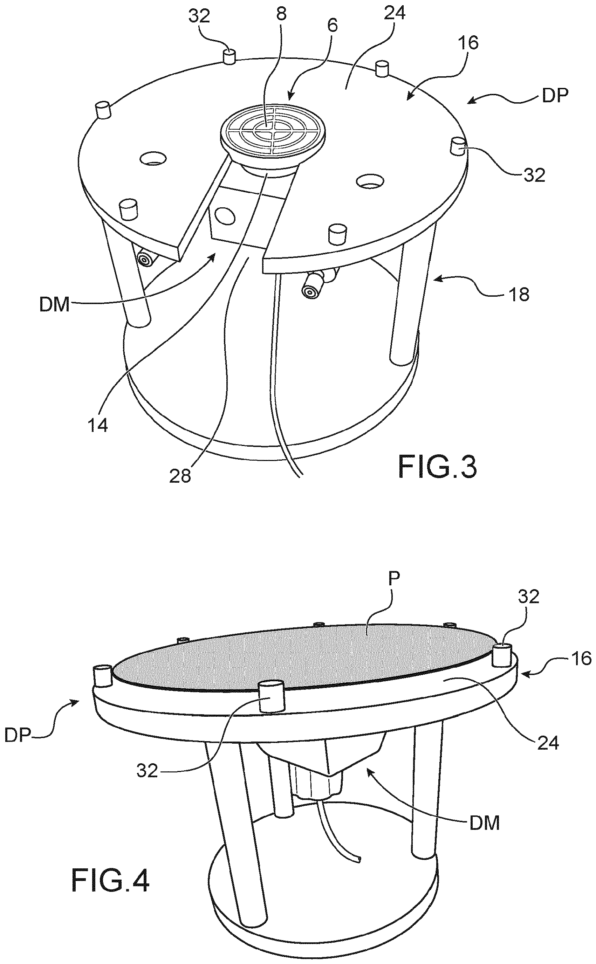

La figure 3 est une vue en perspective du dispositif de manipulation de la figure 2A monté dans le système de positionnement de la figure 1,
La figure 4 est une vue de côté du système de positionnement et du dispositif de manipulation, une plaque étant mise en place,
La figure 5 est une vue en perspective d'un dispositif de collecte de contaminants sur un substrat mettant en oeuvre le dispositif de manipulation,
La figure 6 est une vue en perspective d'un ensemble de collage de plaques comportant deux dispositifs de positionnement et deux dispositifs de manipulation,
La figure 7 est une vue de détail de l'un des dispositifs de positionnement,
La figure 8 est une vue en perspective d'une étape de collage de deux plaques mettant en oeuvre l'ensemble de collage de la figure 6,
La figure 9 est une vue de dessus d'un autre exemple de système de positionnement.

### EXPOSÉ DÉTAILLÉ DE MODES DE RÉALISATION PARTICULIERS

La présente invention est particulièrement intéressante dans le domaine de la microélectronique.

L'exemple d'une plaque en forme de disque, qui est la forme des substrats ou wafers utilisés en microélectronique, sera plus particulièrement décrit dans la description mais l'invention s'applique à des plaques de toutes formes, par exemple rectangulaire.

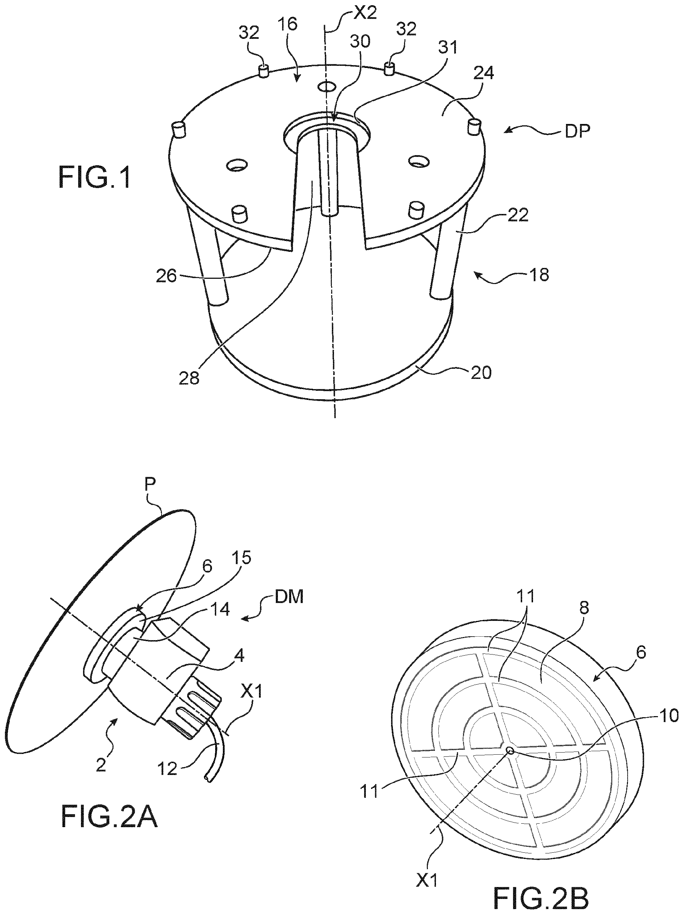

Sur la figure 2A, on peut voir un exemple d'un dispositif de manipulation DM spécialement adapté pour coopérer avec le système de positionnement DP, qui permet de solidariser le dispositif de manipulation DM à un emplacement donné de la plaque P. Le dispositif de manipulation DM comporte un corps 2 muni d'une partie 4 destinée à la préhension du dispositif et une tête 6 reliée au corps présentant une face 8 (cf. Figure 2B) destinée à venir en contact avec une face d'une plaque P et à être solidarisée à celle-ci. La face 8 du dispositif de manipulation DM sera désignée « face de solidarisation ». Un canal débouche sur la face de solidarisation 8 par un trou 10. Le canal est destiné à être relié à une source de vide, telle qu'une pompe à air. La face de solidarisation 8 comporte avantageusement des rainures radiales et des rainures concentriques 11 reliées au trou 10 permettant de répartir la dépression sur l'ensemble de la face 8 (figure 2B). En variante la face comporte plusieurs trous destinés à être reliés à une source de vide. Le dispositif est relié à une source de vide par un tuyau 12. En variante, le dispositif comporte une pompe à vide de taille réduite intégrée directement dans le corps, ou fixée à celui-ci, rendant le dispositif DM encore plus manipulable.

La tête 6 a la forme d'un disque d'axe X1 et est reliée au corps 2 par une portion de jonction 14 de diamètre plus petit que celui de la tête, ménageant ainsi un épaulement 15 avec la tête 6.

Le système de positionnement DP, visible en figure 1, comporte un plateau 16 en forme de disque d'axe X2 supporté par un support 18. Dans l'exemple représenté, le support 18 est un trépied comportant un socle 20 et trois piliers 22 reliant le plateau 16 et le socle 20. Il sera compris que le nombre de piliers n'est pas limitatif, le système DP ne pourrait comporter qu'un unique pilier ayant une forme autorisant l'éq uilibrage du système en présence du dispositif de manipulation DM et d'une plaque P. Cet arrangement présente l'avantage d'offrir une grande stabilité du dispositif, notamment il limite les risques de basculement, notamment par rapport à un socle 20 présentant deux piliers 22. En variante on peut envisager de ne pas mettre en oeuvre de socle, tout en conservant les piliers 22.

La hauteur des piliers est choisie pour permettre au corps 2 du dispositif de manipulation DM de se loger sous le plateau 16, comme cela sera décrit par la suite.

Le plateau 16 comporte une face supérieure 24 et une face inférieure 26, cette dernière étant en regard du socle 20. Le plateau 16 ne forme pas un disque complet et comporte un logement 28 adapté pour recevoir le dispositif de manipulation DM. Dans l'exemple représenté, le logement 28 est configuré de telle sorte que la face de solidarisation 8 du dispositif de manipulation DM fasse saillie de la face supérieure 24 du plateau 16.

Le logement 28 est formé par une encoche. Selon l'exemple illustré, l'encoche est orientée sensiblement radialement. Le logement 28 débouche dans le contour extérieur du plateau 16 et s'étend jusqu'à une partie centrale du plateau. L'encoche présente un fond situé dans la partie centrale du plateau de manière à délimiter le logement 28. Dans cet exemple, le système de positionnement DP est destiné à positionner le centre de la face de solidarisation 8 au centre du plateau 16 et au centre de la plaque P, dans le but de superposer le centre de la plaque P et le centre de la face de solidarisation 8.

Le dispositif de manipulation DM peut être introduit dans le logement 28. La dimension transversale du logement 28 est telle qu'elle permet à la portion de jonction 14 de coulisser dans le logement 28.

De manière avantageuse, le plateau 16 comporte des moyens d'immobilisation 30 pour immobiliser le dispositif DM par rapport au plateau 16. Dans cet exemple, le plateau 16 comporte une rainure 31 bordant le fond du logement 28, la rainure 31 étant configurée pour loger la tête 6 du dispositif. Plus particulièrement, la rainure est délimitée extérieurement par un cercle dont le diamètre est sensiblement égal au diamètre extérieur de la tête, de sorte à permettre de loger la tête dans la rainure 31, tout en l'immobilisant dans le plan du plateau, et ainsi assurer sa position par rapport au plateau. Ainsi, la rainure 31 présente une forme complémentaire à la forme de la tête 6 du dispositif DM.

De manière avantageuse, le système de positionnement comporte des moyens de surélévation de la plaque par rapport au plateau, de sorte à éviter le contact en la face inférieure de la plaque P et le plateau. Le plateau est configuré pour recevoir le dispositif de manipulation dans cette position surélevée. Dans cet exemple, les moyens de surélévation sont formés par la rainure 31 dont la profondeur de la rainure, i.e. sa dimension dans une direction normale au plateau, est inférieure à l'épaisseur du plateau et est inférieure à l'épaisseur de la tête 6, de sorte que la face de solidarisation 8 de la tête 6 soit en saillie de la face supérieure du plateau 16 d'une hauteur h non nulle, ce qui évite un contact entre la face inférieure de la plaque P et la face supérieure 24 du plateau 16, réduisant alors les risques de contamination.

En variante la rainure est telle que la face de solidarisation 8 du dispositif de manipulation DM est sensiblement dans le même plan que la face libre du plateau. Il en résulte un contact important entre le plateau et la plaque.

En variante, une rainure borde également la partie du logement 28 s'étendant jusqu'au bord extérieur du plateau, cette rainure présentant une profondeur égale à celle de la rainure 31 ou différente de celle de la rainure 31.

Par exemple le logement est réalisé par découpe du plateau et la rainure est réalisée par usinage.

Le système de positionnement DP comporte également des éléments pour positionner la plaque P dans une position donnée par rapport au plateau 16 et donc par rapport au logement 28, ce qui permet d'assurer que le dispositif de manipulation DM est dans la position souhaitée par rapport à la plaque P avant sa solidarisation à celle-ci.

Dans cet exemple, les éléments de positionnement comportent des picots ou pions 32 répartis sur la périphérie extérieure de la face supérieure 24 du plateau 16 le long d'un cercle ou de toute autre forme complémentaire de la plaque P. Le contour extérieur de la plaque P est destiné à venir en contact avec une surface latérale de chaque pion 32, ladite surface latérale étant orientée vers le centre du cercle ou de toute autre forme complémentaire formé(e) par l'ensemble des pions 32 sur le plateau 16.

Dans l'exemple représenté, les pions 32 sont de forme cylindrique de révolution. Les pions 32 sont alors disposés de sorte qu'ils définissent entre eux un cercle de diamètre correspondant au diamètre extérieur de la plaque P.

Dans l'exemple représenté, lorsque la plaque P est logée entre les pions 32 elle vient reposer en son centre sur la face de solidarisation 8 du dispositif DM.

Dans cet exemple, six pions 32 sont mis en oeuvre. Le système comporte de préférence au moins trois pions.

De manière avantageuse, les pions 32 sont amovibles par rapport au plateau pour autoriser leur nettoyage. Par exemple, le plateau comporte des évidements de diamètre égal au diamètre extérieur des pions, chaque évidement recevant une extrémité d'un pion.

Selon un autre exemple, les pions ont une forme conique ou tronconique dont la base est en contact avec le plateau. Les pions sont alors disposés de sorte qu'ils définissent entre eux un cercle de diamètre correspondant au diamètre extérieur de la plaque, ainsi lorsque la plaque est disposée entre les pions elle vient en appui par son contour radialement extérieur contre la face latérale de chacun des pions. Dans la configuration où la face de solidarisation 8 du dispositif de manipulation DM fait saillie par rapport à la face supérieure du plateau 16, la plaque P est positionnée entre les pions 32, elle se situe à une hauteur h au-dessus de la face supérieure du plateau 16. La distance entre la face de solidarisation 8 du dispositif de manipulation DM et la face supérieure 24 du plateau 16 est au plus égale à la hauteur h. En effet, on peut prévoir un jeu entre la face de solidarisation 8 du dispositif de manipulation DM et la plaque P, ce jeu étant annulé lors de l'aspiration.

La mise en oeuvre de pions coniques ou tronconiques présente l'avantage de rendre le système de positionnement compatible avec plusieurs diamètres de plaque.

De manière avantageuse, le système de positionnement ainsi que le dispositif de manipulation sont réalisés dans un matériau qui est facilement nettoyable, par exemple le système de positionnement est réalisé en polytétrafluoroéthylène, par exemple commercialisé sous la marque Téflon^{®}. La température de fusion du polytétrafluoroéthylène est 327°C, ce qui rend le système de positionnement ainsi que le dispositif de manipulation fabriqués en une telle matière non adaptés à une utilisation dans un réacteur de gravure de substrat.

Le système de positionnement et/ou le dispositif de manipulation peut ou peuvent être réalisé(s) entièrement dans le même matériau ou être réalisé(s) en plusieurs matériaux. En variante, les pions sont remplacés par un cadre annulaire ou rectangulaire présentant la forme et les dimensions extérieures de la plaque. Dans cette variante, la surface de contact entre la plaque et le système de positionnement est augmentée.

L'utilisation du système de positionnement va maintenant être décrite dans le but de fixer le dispositif de manipulation au centre d'une plaque P circulaire pouvant être mis en oeuvre en microélectronique, et pour lequel on souhaite limiter la contamination lors de le l'étape de positionnement et de fixation du dispositif de manipulation à la plaque P. La plaque P est par exemple un substrat en matériau semi-conducteur destiné par exemple à la fabrication de circuit imprimée.

Tout d'abord, les pions 32 sont conditionnés afin d'éviter une potentielle contamination du contour extérieur ou bevel de la plaque. Pour cela, les pions sont retirés du plateau et sont conditionnés au moyen de solutions permettant de collecter les métaux standards et les métaux nobles.

Les pions sont ensuite remis en place sur le plateau 16.

Le dispositif de manipulation DM est mis en place dans le logement 28. La portion de jonction 14 coulisse dans le logement 28 jusqu'à venir en butée contre le fond du logement 28, dans le cas représenté, au centre de plateau 16. La tête 6 se trouve alors à l'aplomb de la rainure 31, la tête est ensuite abaissée et se loge dans la rainure 31. La face de solidarisation 8 est alors centrée par rapport au plateau 16 et aux pions 32 et est immobilisée dans le plan du plateau 16. Dans cet exemple, la face de solidarisation 8 fait saillie de la face supérieure du plateau 16.

La plaque P est ensuite mis en place entre les pions 32 de manière à ce qu'elle soit calée contre les pions 32 et ainsi centrer par rapport au plateau 16. Pour cela, la plaque a par exemple été manipulée avec une pipette à vide qui a été nettoyée au préalable.

Le dispositif de manipulation DM est alimenté en vide, ce qui a pour effet de solidariser la face de solidarisation 8 et la plaque P.

La plaque P peut ensuite être manipulée par l'intermédiaire du dispositif de manipulation DM, qui peut être retiré du système de positionnement DP.

Pour retirer le dispositif de manipulation du système de positionnement, le dispositif de manipulation DM est déplacé vers le haut le long de l'axe X2 pour dégager la tête 6 de la rainure 31, puis il est coulissé dans le logement 28 vers l'extérieur pour sortir le dispositif de manipulation du système de positionnement. L'opérateur est ensuite libre de manipuler/transporter la plaque en vue par exemple d'une collecte de contaminants sur les bords et le bevel de la plaque ou d'un assemblage avec une autre plaque comme cela sera décrit ci-dessous.

La séparation de la plaque P et du dispositif de manipulation DM s'effectue en mettant à l'air l'interface entre le dispositif de manipulation DM et la plaque P.

Un dispositif de collecte de contaminants sur les bords et la tranche d'un substrat en forme de disque va maintenant être décrit rapidement.

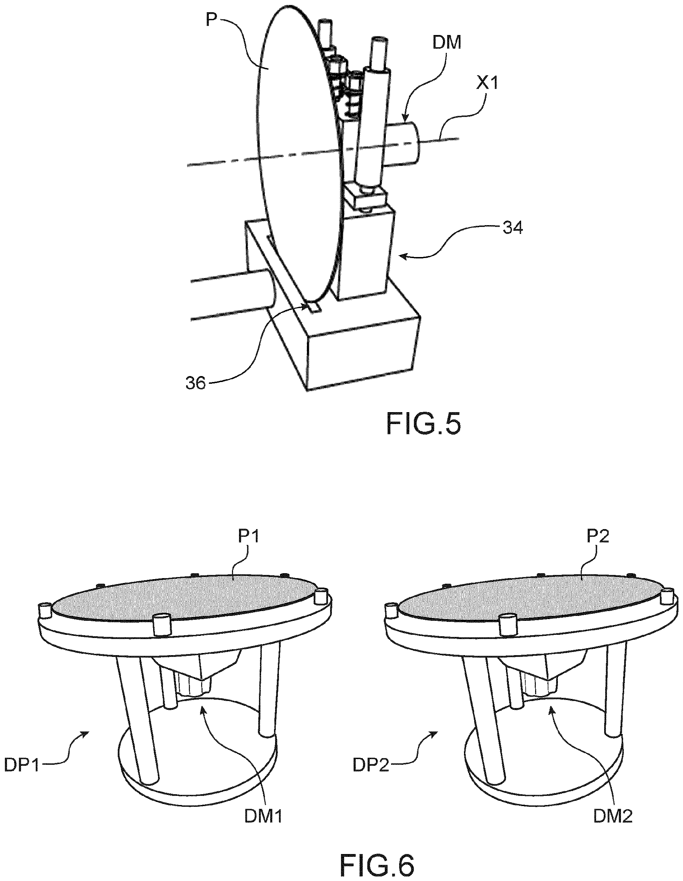

Sur la figure 5, on peut voir un dispositif de collecte de contaminants sur un substrat dans lequel le dispositif de manipulation est mis en oeuvre.

Le dispositif de collecte comporte un support 34 pour le substrat de sorte qu'il puisse tourner autour de son axe de révolution, une rainure 36 destinée à contenir un liquide de collecte, la rainure 36 étant située par rapport au support 34 de sorte qu'au moins la tranche ou une portion des bords des deux faces et la tranche du substrat pénètrent dans la rainure et entrent en contact avec le liquide de collecte.

Le substrat est monté dans le dispositif de collecte par l'intermédiaire du dispositif de manipulation, ce dernier étant monté sur le support 34 de sorte à pouvoir tourner autour d'un axe horizontal.

Le dispositif de manipulation DM forme l'axe de rotation du substrat. Il est donc important que le dispositif de manipulation soit au centre du substrat, afin que la largeur de collecte sur les bords de la plaque soit la même sur un tour entier du substrat, afin de connaître la surface de collecte et ainsi pouvoir calculer la concentration d'éléments collectés, connaissant la surface de collecte et la quantité de contaminants collectée par le liquide dans la rainure.

Or, grâce à l'invention, un tel positionnement très précis du dispositif de manipulation par rapport à la plaque est rendu possible et ceci de manière simple et rapide tout en limitant les risques de contamination.

Sur les figures 6 à 8, on peut voir un autre exemple d'utilisation du système de positionnement utilisé pour réaliser un collage moléculaire ou bonding entre deux plaques, en particuliers des substrats mis en oeuvre en microélectronique, par exemple deux plaques en Si/SiO2, Au/Au, Ti/Ti, SiO2/LNO, SiO2/LTO, LNO/LNO, LTO/LTO.... Les matériaux assurant le collage moléculaire peuvent être le matériau avec lequel les plaques sont faites, ou uniquement celui d'une couche en face avant tel que l'Au, Ti....

Le collage moléculaire est compris comme le collage par adhésion moléculaire au cours duquel deux surfaces planes adhèrent l'une à l'autre sans application de colle entre les deux surfaces.

Dans cet exemple, deux dispositifs de positionnement DP1 et DP2 sont mis en oeuvre. Dans cet exemple, les dispositifs de positionnement sont tels que la solidarisation du dispositif de manipulation DM1, DM2 à la plaque s'effectue dans une zone excentrée Zex de la plaque.

Dans cet exemple particulier, au moins l'un des dispositifs de positionnement permet en outre d'orienter spécifiquement chaque plaque.

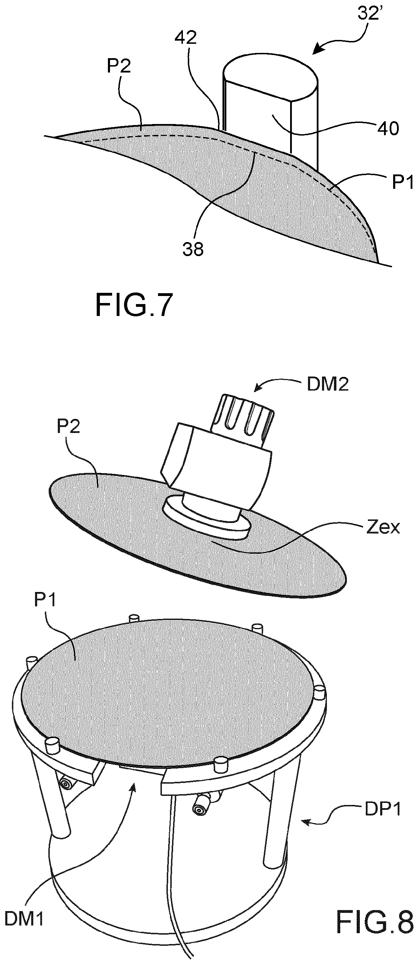

Les plaques circulaires utilisées en microélectronique comprennent généralement un méplat ou une encoche, désignée « notch » en terminologie anglo-saxonne sur leur contour extérieur. Sur la figure 7, les plaques P1, P2 comportent chacune un méplat 38, 42 respectivement.

Au moins le système de positionnement DP1 portant la plaque P1 comporte des moyens pour localiser le méplat 38, sur le plateau 16. Dans l'exemple représenté sur la figure 7, un des pions 32' comporte également un méplat 40 dans sa face latérale contre lequel le méplat 38 de la plaque est destiné à venir en appui.

Sur chaque système de positionnement DP1, DP2 est monté un dispositif de manipulation DM1, DM2. Chaque dispositif de manipulation est introduit dans le logement et est immobilisé dans l'extrémité 28.2 du logement 28.

Une plaque P1 est disposée entres les pions 32 en appui sur la face de solidarisation du dispositif de manipulation DM1 et le méplat 38 en appui contre le méplat 40 du pion 32'. Une plaque P2 est disposée entres les pions 32 en appui sur la face de solidarisation du dispositif de manipulation DM2, l'emplacement du méplat 42 n'est pas nécessairement maîtrisé.

La face de solidarisation de chaque dispositif de manipulation DM1, DM2 est reliée au vide assurant la solidarisation du dispositif de manipulation en un emplacement donné de chaque plaque P1, P2.

L'opérateur laisse l'une des plaques en position sur le système de positionnement, par exemple la plaque P1, et il retire la plaque P2 de son système de positionnement au moyen du dispositif de manipulation DM2, comme expliqué ci-dessus et vient placer la face libre de la plaque P2 en regard de la plaque P1 tout en positionnant le méplat 42 de la plaque P2 contre le méplat 40 du pion du système de positionnement, de sorte que le méplat 38 de la plaque P1 soit superposé au méplat 42 de la plaque P2.

Dans le cas d'une plaque munie d'un notch, un pion comporte une saillie radiale destiné à loger dans le notch.

L'opérateur abaisse la plaque P2 pour mettre en contact les deux faces libres des plaques P1 et P2 (figure 8).

Dans les exemples décrits ci-dessus, un système de positionnement est configuré pour assurer un positionnement donné d'un dispositif de manipulation par rapport à la plaque. Dans un autre exemple, on peut envisager que le système de positionnement puisse permettre différents positionnements, par exemple l'extension radiale du logement 28 pourrait être modifiée pour modifier la position du dispositif de manipulation par rapport à la plaque. Par exemple, un jeu de cales peut être prévu, les cales se montant dans le logement afin de modifier l'emplacement où le dispositif de manipulation est monté dans le plateau.

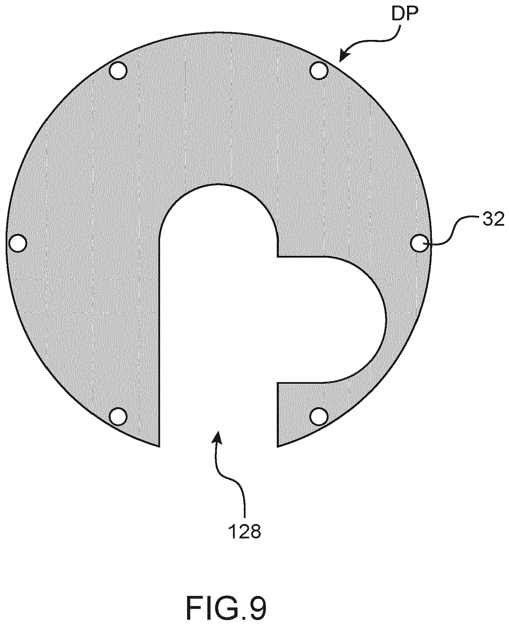

Sur la figure 9, on peut voir un exemple d'un logement 128 permettant soit de centrer la tête du dispositif de manipulation sur la plaque, soit de positionner ladite tête de manière décentrée, par exemple en vue d'un collage.

Dans un exemple avantageux, on peut envisager d'utiliser le même système de positionnement pour différentes dimensions de plaque. Par exemple on prévoit un plateau dont les dimensions extérieures permettent de positionner les pions de sorte à recevoir une première plaque ayant les plus grandes dimensions que l'on souhaite manipuler. Ce plateau comporte des jeux d'évidements dans sa face destinée à être en regard de la plaque à manipuler, ces évidements étant configurés pour recevoir une extrémité d'un pion et les pions de chaque jeu étant disposés les uns par rapport aux autres de sorte à délimiter un emplacement pour une plaque de dimensions extérieures inférieures à celles de la première plaque.

Par exemple, lorsque les plaques à manipuler sont circulaires, les jeux d'évidements sont concentriques.

Ainsi le système de positionnement est facilement adaptable à plusieurs dimensions de plaques.

Dans les exemples décrits, le système de positionnement comporte un plateau horizontal. Néanmoins des dispositifs de positionnement avec des plateaux inclinés par rapport à l'horizontal voir des plateaux quasi à la verticale ne sortent pas du cadre de la présente invention, ladite invention étant définie par le jeu de revendications annexé. If

## Revendications

1. Système de positionnement pour positionner un dispositif de manipulation (DM) de plaque (P) par rapport à une plaque (P) de forme donnée, ledit dispositif de manipulation (DM) comportant une face de solidarisation destinée à être solidarisée à une face de la plaque, ledit système comprenant :
- un plateau (16) comportant une première face (26) et une deuxième face (24), la deuxième face (24) étant destinée à être au moins en partie en regard d'une face de la plaque (P),
- un support (18) supportant le plateau (16),
- des éléments de positionnement pour positionner la plaque (P) par rapport au plateau (16), lesdits éléments de positionnement étant portés par la deuxième face (24) du plateau (16),
- un logement (28) pour monter le dispositif de manipulation (DM) dans le plateau (16), de sorte que ladite face de solidarisation (8) du dispositif de manipulation (DM) soit orientée du côté de la deuxième face (24) du plateau (16), la position du logement (28) par rapport aux éléments de positionnement assurant le positionnement du dispositif de manipulation (DM) par rapport à la plaque (P), ledit logement (28) débouchant dans un contour extérieur du plateau de sorte à permettre la mise en place du dispositif de manipulation (DM) dans le logement (28) et le retrait du dispositif de manipulation (DM) du logement (28).

2. Système de positionnement selon la revendication 1, dans lequel les éléments de positionnement sont configurés pour venir en contact avec un contour extérieur de la plaque (P) de sorte à former une butée en translation pour la plaque dans un plan parallèle à celui de la deuxième face (24) du plateau ou dans un plan confondu avec celui de la deuxième face (24) du plateau.

3. Système de positionnement selon la revendication 2, dans lequel les éléments de positionnement comportent au moins trois pions (32) en saillie de la deuxième face du plateau (16) et disposés les uns par rapport aux autres de sorte à délimiter entre eux le contour extérieur de la plaque (P).

4. Système de positionnement selon l'une des revendications 1 à 3, dans lequel le logement est formé par une encoche, l'encoche comportant des bords configurés pour venir en butée contre le dispositif de manipulation (DM).

5. Système de positionnement selon l'une des revendications 1 à 4, dans lequel le plateau (16) comporte des moyens d'immobilisation pour immobiliser le dispositif de manipulation dans le plan du plateau.

6. Système de positionnement selon la revendication précédente en combinaison avec la revendication 4, dans lequel les moyens d'immobilisation comportent une rainure (31) dans les bords de l'ouverture (28).

7. Système de positionnement selon l'une des revendications précédentes, dans lequel les pions (32) sont amovibles pour autoriser leur nettoyage.

8. Système de positionnement selon l'une des revendications 1 à 7, dans lequel au moins les éléments de positionnement sont en polytétrafluoroéthylène.

9. Ensemble de manipulation comportant un système de positionnement (DP) selon l'une des revendications précédentes et un dispositif de manipulation (DM) comportant un corps (2), une tête (6) munie d'une face de solidarisation (8), la tête (6) étant configurée pour que la face de solidarisation (8) soit orientée du côté de la deuxième face (24) du plateau (16) et le corps (2) soit de l'autre côté du plateau (16) par rapport à la face de solidarisation (8).

10. Ensemble de manipulation selon la revendication 9, dans lequel la tête (6) du dispositif de manipulation (DM) comporte des dimensions supérieures à la dimension transversale du logement (28), et dans lequel la tête (6) est reliée au corps (2) par une partie de jonction (14) de dimensions transversales inférieures à la dimension transversale du logement (28), de sorte que la tête (6) puisse reposer sur la deuxième face (24) du plateau (16) et que la partie de jonction (14) puisse coulisser dans le logement (28).

11. Ensemble de manipulation selon la revendication 9 ou 10, dans lequel le dispositif de manipulation (DM) comporte au moins un canal débouchant dans la face de solidarisation (8) et relié à une source de dépression.

12. Ensemble de manipulation selon la revendication précédente, dans lequel la face de solidarisation (8) comporte des rainures (11) reliées au canal.

13. Ensemble de manipulation selon la revendication précédente, dans lequel la face de solidarisation (8) comporte des premières rainures (11) en cercles concentriques de différents diamètres et au moins une deuxième rainure rectiligne disposée radialement et croisant les première rainures, lesdites première rainure et ladite au moins deuxième rainure étant reliées au canal.

14. Ensemble d'assemblage pour l'assemblage de deux plaques comportant deux ensembles de manipulation selon l'une des revendications 9 à 13, ledit ensemble étant avantageusement configuré pour assembler deux plaques (P1, P2) en forme de disque comportant chacune un méplat (38, 42) ou une encoche sur son contour, les éléments de positionnement d'au moins un système de positionnement étant tels qu'ils imposent une localisation du méplat ou de l'encoche sur le plateau.

15. Procédé d'assemblage d'une première et d'une deuxième plaque (P1, P2) mettant en oeuvre l'ensemble d'assemblage selon la revendication 14, comportant :
- Une mise en place dans un premier et deuxième système de positionnement (DP1, DP2) d'un premier et deuxième dispositif de manipulation (DM1, DM2) respectivement.
- Une mise en place des première et deuxième plaques sur les premier et deuxième dispositifs de positionnement respectivement.
- Une solidarisation des première et deuxième plaques au premier et deuxième dispositif de manipulation respectivement.
- Un retrait du deuxième dispositif de manipulation et de la deuxième plaque du deuxième dispositif de positionnement.
- Un rapprochement de la deuxième plaque de la première plaque.
- La mise en contact des première et deuxième plaques par leur face opposée à celle en contact avec les premier et deuxième dispositifs de manipulation.

## Patentansprüche

1. Positionierungssystem zum Positionieren einer Handhabungsvorrichtung (DM) einer Platte (P) in Bezug auf eine Platte (P) einer gegebenen Form, wobei die Handhabungsvorrichtung (DM) eine Seite zum festen Verbinden beinhaltet, die dazu bestimmt ist, fest mit einer Seite der Platte verbunden zu werden, wobei das System umfasst:
- eine Scheibe (16), die eine erste Seite (26) und eine zweite Seite (24) beinhaltet, wobei die zweite Seite (24) dazu bestimmt ist, mindestens teilweise gegenüber einer Seite der Platte (P) zu sein,
- eine Stütze (18), die die Scheibe (16) stützt,
- Positionierungselemente zum Positionieren der Platte (P) in Bezug auf die Scheibe (16), wobei die Positionierungselemente von der zweiten Seite (24) der Scheibe (16) getragen werden,
- einen Sitz (28) zum Anbringen der Handhabungsvorrichtung (DM), sodass die Seite zum festen Verbinden (8) der Handhabungsvorrichtung (DM) der zweiten Seite (24) der Scheibe (16) zugewandt ist, wobei die Position des Sitzes (28) in Bezug auf die Positionierungselemente für die Positionierung der Handhabungsvorrichtung (DM) in Bezug auf die Platte (P) sorgt, wobei der Sitz (28) in eine Außenkontur der Scheibe mündet, um das Einführen der Handhabungsvorrichtung (DM) in den Sitz (28) und die Entnahme der Handhabungsvorrichtung (DM) aus dem Sitz (28) zu ermöglichen.

2. Positionierungssystem nach Anspruch 1, wobei die Positionierungselemente konfiguriert sind, um in Kontakt mit einer Außenkontur der Platte (P) zu gelangen, um einen Vorschubanschlag für die Platte in einer Ebene parallel zu jener der zweiten Seite (24) der Scheibe oder in einer Ebene zu bilden, die mit jener der zweiten Seite (24) der Scheibe zusammengenommen ist.

3. Positionierungssystem nach Anspruch 2, wobei die Positionierungselemente mindestens drei Klötze (32) beinhalten, die aus der zweiten Seite der Scheibe (16) hervorstehen, und in Bezug zueinander angeordnet sind, um zwischen sich die Außenkontur der Platte (P) zu begrenzen.

4. Positionierungssystem nach einem der Ansprüche 1 bis 3, wobei der Sitz durch eine Kerbe gebildet wird, wobei die Kerbe Ränder beinhaltet, die konfiguriert sind, um auf Anschlag an die Handhabungsvorrichtung (DM) zu gelangen.

5. Positionierungssystem nach einem der Ansprüche 1 bis 4, wobei die Scheibe (16) Immobilisierungsmittel zum Immobilisieren der Handhabungsvorrichtung in der Ebene der Scheibe beinhaltet.

6. Positionierungssystem nach dem vorstehenden Anspruch, in Kombination mit Anspruch 4, wobei die Immobilisierungsmittel eine Nut (31) in den Rändern der Öffnung (28) beinhalten.

7. Positionierungssystem nach einem der vorstehenden Ansprüche, wobei die Klötze (32) abnehmbar sind, um deren Reinigung zu ermöglichen.

8. Positionierungssystem nach einem der Ansprüche 1 bis 7, wobei mindestens die Positionierungselemente aus Polytetrafluorethylen sind.

9. Handhabungseinheit, die ein Positionierungssystem (DP) nach einem der vorstehenden Ansprüche und eine Handhabungsvorrichtung (DM) beinhaltet, die einen Körper (2), einen Kopf (6), der mit einer Seite zum festen Verbinden (8) versehen ist, beinhaltet, wobei der Kopf (6) konfiguriert ist, damit die Seite zum festen Verbinden (8) der zweiten Seite (24) der Scheibe (16) zugewandt ist, und sich der Körper (2) auf der anderen Seite der Scheibe (16) in Bezug auf die Seite zum festen Verbinden (8) befindet.

10. Handhabungseinheit nach Anspruch 9, wobei der Kopf (6) der Handhabungsvorrichtung (DM) Abmessungen beinhaltet, die größer als die Querabmessung des Sitzes (28) ist, und wobei der Kopf (6) durch einen Verbindungsabschnitt (14) mit Querabmessungen, die kleiner als die Querabmessung des Sitzes (28) sind, mit dem Körper (2) verbunden ist, sodass der Kopf (6) auf der zweiten Seite (24) der Scheibe (16) aufliegen kann, und der Verbindungsabschnitt (14) in dem Sitz (28) gleiten kann.

11. Handhabungseinheit nach Anspruch 9 oder 10, wobei die Handhabungsvorrichtung (DM) mindestens einen Kanal beinhaltet, der in die Seite zum festen Verbinden (8) mündet und mit einer Unterdruckquelle verbunden ist.

12. Handhabungseinheit nach dem vorstehenden Anspruch, wobei die Seite zum festen Verbinden (8) Nuten (11) beinhaltet, die mit dem Kanal verbunden sind.

13. Handhabungseinheit nach dem vorstehenden Anspruch, wobei die Seite zum festen Verbinden (8) erste Nuten (11) in konzentrischen Kreisen mit unterschiedlichen Durchmessern, und mindestens eine zweite geradlinige Nut beinhaltet, die radial angeordnet ist, und die ersten Nuten kreuzt, wobei die erste Nut und die mindestens zweite Nut mit dem Kanal verbunden sind.

14. Zusammensetzungseinheit zum Zusammensetzen zweier Platten, die zwei Handhabungseinheiten nach einem der Ansprüche 9 bis 13 beinhalten, wobei die Einheit vorteilhafterweise konfiguriert ist, um zwei Platten (P1, P2) in Form einer Kreisscheibe zusammenzusetzen, die jeweils eine Abflachung (38, 42) oder eine Kerbe an ihrer Kontur beinhaltet, wobei die Positionierungselemente mindestens eines Positionierungssystems dergestalt sind, dass sie eine Lokalisierung der Abflachung oder der Kerbe auf der Scheibe vorschreiben.

15. Verfahren zum Zusammensetzen einer ersten und einer zweiten Platte (P1, P2), welches die Zusammensetzungseinheit nach Anspruch 14 einsetzt, Folgendes beinhaltend:
- Anbringen in einem ersten und zweiten Positionierungssystem (DP1, DP2) jeweils einer ersten und zweiten Handhabungsvorrichtung (DM1, DM2).
- Anbringen der ersten und zweiten Platten jeweils auf den ersten und zweiten Positionierungsvorrichtungen.
- festes Verbinden der ersten und zweiten Platten jeweils an der ersten und zweiten Handhabungsvorrichtung.
- Entnehmen der zweiten Handhabungsvorrichtung und der zweiten Platte von der zweiten Positionierungsvorrichtung.
- Annähern der zweiten Platte an die erste Platte.
- In-Kontakt-bringen der ersten und zweiten Platten an ihrer gegenüberliegenden Seite mit jener, die in Kontakt mit der ersten und zweiten Handhabungsvorrichtung ist.

## Claims

1. A positioning system for positioning a plate (P) handling device (DM) relative to a plate (P) of a given shape, said handling device (DM) having a securing face to be secured to a face of the plate, said system comprising:
- a tray (16) comprising a first face (26) and a second face (24), the second face (24) being to face at least partly a face of the plate (P),
- a support (18) supporting the tray (16),
- positioning elements for positioning the plate (P) relative to the tray (16), said positioning elements being carried by the second face (24) of the tray (16),
- a housing (28) for mounting the handling device (DM) in the tray (16), so that said face for securing (8) the handling device (DM) is oriented to the side of the second face (24) of the tray (16), the position of the housing (28) relative to the positioning elements ensuring positioning of the handling device (DM) relative to the plate (P), said housing (28) opening into an external contour of the tray so as to allow the handling device (DM) to be placed in the housing (28) and the handling device (DM) to be removed from the housing (28).

2. The positioning system according to claim 1, wherein the positioning elements are configured to contact an external contour of the plate (P) so as to form a translational abutment for the plate in a plane parallel to that of the second face (24) of the tray or in a same plane as that of the second face (24) of the tray.

3. The positioning system according to claim 2, wherein the positioning elements comprise at least three pins (32) protruding from the second face of the tray (16) and disposed relative to each other so as to delimit the external contour of the plate (P) between them.

4. The positioning system according to any of claims 1 to 3, wherein the housing is formed by a notch, the notch comprising edges configured to abut the handling device (DM).

5. The positioning system according to any of claims 1 to 4, wherein the tray (16) includes immobilising means for immobilising the handling device in the plane of the tray.

6. The positioning system according to preceding claim in combination with claim 4, wherein the immobilising means include a groove (31) in the edges of the opening (28).

7. The positioning system according to any of the preceding claims, wherein the pins (32) are removable to allow cleaning thereof.

8. The positioning system according to any of claim 1 to 7, wherein at least the positioning elements are of polytetrafluoroethylene.

9. A handling assembly comprising a positioning system (DP) according to any of the preceding claims and a handling device (DM) comprising a body (2), a head (6) fitted with a securing face (8), the head (6) being configured so that the securing face (8) is oriented to the side of the second face (24) of the tray (16) and the body (2) is on the other side of the tray (16) relative to the securing face (8).

10. The handling assembly according to claim 9, wherein the head (6) of the handling device (DM) has dimensions greater than the transverse dimension of the housing (28), and wherein the head (6) is connected to the body (2) through a joining portion (14) with transverse dimensions less than the transverse dimension of the housing (28), such that the head (6) can rest on the second face (24) of the tray (16) and the joining portion (14) can slide within the housing (28).

11. The handling assembly according to claim 9 or 10, wherein the handling device (DM) comprises at least one channel opening into the securing face (8) and connected to a low pressure source.

12. The handling assembly according to the preceding claim, wherein the securing face (8) comprises grooves (11) connected to the channel.

13. The handling assembly according to the preceding claim, wherein the securing face (8) includes first grooves (11) in concentric circles with different diameters and at least one second rectilinear groove disposed radially and crossing the first grooves, said first grooves and said at least second groove being connected to the channel.

14. An assembling system for assembling two plates comprising two handling assemblies according to any of claims 9 to 13, said system being advantageously configured to assemble two disc-shaped plates (P1, P2) each comprising a flat (38, 42) or a notch on its contour, the positioning elements of at least one positioning system being such that they fix the location of the flat or the notch on the tray.

15. A method for assembling a first and a second plate (P1, P2) implementing the assembling assembly according to claim 14, including:
- Placing in the first and second positioning systems (DP1, DP2) a first and second handling device (DM1, DM2) respectively.
- Placing the first and second plates on the first and second positioning devices respectively.
- Securing the first and second plates to the first and second handling devices respectively.
- Removing the second handling device and the second plate from the second positioning device.
- Bringing the second plate closer to the first plate.
- Bringing the first and second plates into contact with each other through their face opposite to that in contact with the first and second handling devices.
